# FASCICULE DE BREVET EUROPEEN

(11) **EP 1 474 866 B1**
(45) Date de publication et mention de la délivrance du brevet: **29.08.2012**
(21) Numéro de dépôt: 03739523.3
(22) Date de dépôt: 11.02.2003
(51) Int. Cl.: H03H 9/17

(54) **MICRORESONATEUR MEMS A ONDES ACOUSTIQUES DE VOLUME ACCORDABLE**
ABSTIMMBARER HAUPTKÖRPER-OBERFLÄCHENWELLEN-MEMS-MIKRORESONATOR
TUNABLE BULK ACOUSTIC WAVE MEMS MICRORESONATOR

(30) Priorité: 13.02.2002 FR 0201759
(43) Date de publication de la demande: 10.11.2004
(73) Titulaire: Commissariat à l'Énergie Atomique et aux Énergies Alternatives, 75015 Paris (FR)
(72) Inventeur: ROBERT, Philippe, F-38100 GRENOBLE (FR)
(74) Mandataire: Poulin, Gérard
(86) Numéro de dépôt international: PCT/FR2003/000427
(87) Numéro de publication internationale: WO 2003/069776

(56) Documents cités:
- US-A- 5 446 306
- US-A1- 2001 022 546

## Description

### Domaine technique

La présente invention concerne un microrésonateur MEMS (de l'anglais "micro-electro-mechanical system") à ondes acoustiques de volume accordable.

### Etat de la technique antérieure

Dans une chaîne d'émission-réception pour communications mobiles par exemple, plusieurs niveaux de filtrage sont nécessaires: en sortie d'antenne, comme filtre de bande ou de réjection, etc... Actuellement, pour réaliser des filtres RF, deux solutions principales sont exploitées:
- les composants SAW (de l'anglais "surface acoustic wave") qui donnent d'excellents résultats mais qui ne sont pas intégrables directement dans les circuits intégrés ;
- les circuits RLC qui sont intégrables mais dont les caractéristiques sont médiocres compte tenu des performances de chacun des composants, en particulier de la self (le facteur de qualité d'une self intégrée dépasse difficilement 30).

Un troisième axe de recherche apparaît, basé sur l'utilisation de résonateurs mécaniques à ondes acoustiques de volume ou FBAR (de l'anglais "film bulk acoustic resonator"). Ces résonateurs peuvent être intégrés et offrent des facteurs de qualité importants (supérieurs à 1000). Ce sont par conséquent des dispositifs intéressants puisqu'ils permettent a priori d'associer de bonnes performances (facteur de qualité élevé) et un faible coût de production (dispositifs intégrables).

Les résonateurs à ondes acoustiques se classent donc en deux catégories: les résonateurs à ondes acoustiques de surface ou SAW et les résonateurs à ondes acoustiques de volume ou FBAR.

Pour les résonateurs SAW, une onde de surface est générée en excitant un matériau piézoélectrique (quartz, LiNbO₃, LiTaO₃) par un réseau d'électrodes en peigne. La détection de cette onde se fait par un deuxième jeu d'électrodes interdigitées. La largeur, l'écartement et le nombre de peignes d'excitation et de détection conditionnent la fréquence de résonance de l'oscillateur ou la bande passante du filtre. Les filtres SAW sont utilisés dans des gammes de fréquence allant de 100 MHz à environ 2,5 GHz. La surface de ces dispositifs, qui est de plusieurs mm², ainsi que les matériaux piézoélectriques utilisés (quartz, LiNbO₃, LiTaO₃...) rendent le principe peu adapté à une réalisation sur circuit intégré. Bien que performant et largement éprouvé, ce type de composant paraît par conséquent plutôt réservé à une technologie d'hybridation.

Dans le cas des résonateurs FBAR, une onde acoustique de volume est générée par l'excitation d'une couche mince piézoélectrique (en AlN, PZT ou ZnO) comprise entre deux électrodes. Pour ces résonateurs micro-mécaniques, les filtres sont généralement réalisés en couplant plusieurs de ces résonateurs entre eux. Les fréquences de résonance des résonateurs, qui sont généralement proches, fixent la fréquence centrale du filtre. La bande passante du filtre dépend des caractéristiques du couplage (position, rigidité) tandis que le nombre de résonateurs donne l'ordre du filtre. Ce type de résonateur permet de réaliser des filtres dans la gamme 300 MHz-12,5 GHz.

On peut classer les résonateurs FBAR en deux groupes appelés dans la littérature spécialisée FBAR-MEMS et SMR. Dans le cas des FBAR-MEMS, le résonateur en matériau piézoélectrique est écarté du substrat pour éviter toute dissipation des ondes acoustiques. Cet écartement est obtenu soit par gravure de la face arrière du substrat, soit en suspendant le résonateur par l'utilisation d'une couche sacrificielle. Dans le cas des SMR (pour "Solidly Mounted Resonator"), on utilise un réseau de Bragg acoustique sous le résonateur en matériau piézoélectrique. Ce réseau de Bragg acoustique est constitué d'un multicouche de matériaux, chaque couche du multicouche ayant une épaisseur de λ/4 (λ étant la longueur d'onde correspondant à la fréquence du résonateur) et présentant un module de Young très différent d'une couche à l'autre. Ce multicouche est destiné à réfléchir l'onde acoustique.

Pour ces types de résonateurs à ondes acoustiques de volume, la fréquence de résonance est inversement proportionnelle à l'épaisseur de la couche piézoélectrique. Dans le cas d'un résonateur en AlN par exemple, une fréquence de 1 GHz est obtenue pour une épaisseur d'environ 1 µm.

Dans les applications RF, on recherche classiquement des fréquences de résonance de l'ordre du gigahertz, correspondant à des épaisseurs de matériau piézoélectrique voisines de micromètre (généralement de 1 à quelques micromètres) avec un contrôle de cette fréquence à quelques MHz ou dizaines de MHz. Cette variation de fréquence correspond à un contrôle de l'épaisseur de la couche de matériau piézoélectrique du résonateur à moins de 10 nm (correspondant à une dispersion inférieure à 1%). D'un point de vue industriel, ce contrôle de l'épaisseur n'est guère envisageable.

Par ailleurs, aucun de ces composants de l'art antérieur n'est accordable.

Le document US 5 446 306 divulgue un résonateur à ondes acoustiques de volume comprenant un film piézoélectrique pris en sandwich, selon son épaisseur, entre deux électrodes d'excitation recevant une tension continue. Les mêmes électrodes servent à soumettre le film piézoélectrique à une tension alternative afin de faire varie la fréquence de résonance du résonateur.

### Exposé de l'invention

La présente invention permet de combler cette lacune de l'art antérieur au moyen d'un résonateur de type FBAR-MEMS (c'est-à-dire un résonateur à ondes acoustiques de volume suspendu) disposant d'un système permettant d'exercer une contrainte mécanique variable sur le résonateur.

Elle a pour objet un microrésonateur à ondes acoustiques de volume suspendu, comprenant une poutre en matériau piézoélectrique solidaire d'un support et d'épaisseur prévue pour fonctionner à une fréquence de résonance donnée, la poutre étant prise en sandwich selon son épaisseur entre des électrodes d'excitation, le microrésonateur comprenant en outre des moyens piézoélectriques permettant de modifier ladite fréquence de résonance, caractérisé en ce que les moyens piézoélectriques comprennent, sur au moins l'une des faces de la poutre, des électrodes, dont au moins une est une électrode supplémentaire différente des électrodes d'excitation, permettant l'application d'un champ électrique à la poutre, d'où il résulte une contrainte de compression/dilatation ou de cisaillement dans le plan de la poutre.

L'une des électrodes des moyens piézoélectriques peut être une électrode d'excitation.

La poutre en matériau piézoélectrique munie de ses électrodes d'excitation peut être solidaire du support par l'intermédiaire d'une couche en matériau diélectrique.

### Brève description des dessins

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1 est la vue en coupe d'un microrésonateur selon une première variante et ne faisant pas partie de l'invention,
- la figure 2 est une vue en coupe d'un autre microrésonateur selon la première variante et ne faisant pas partie de l'invention,
- la figure 3 est une vue en coupe d'encore un autre microrésonateur selon la première variante et ne faisant pas partie de l'invention,
- les figures 4 à 6 sont des vues de dessus illustrant plusieurs configurations possibles pour le microrésonateur de la figure 2,
- la figure 7 est une vue en coupe d'encore un autre microrésonateur selon la première variante et faisant partie de l'invention,
- les figures 8 à 10 sont des vues de dessus illustrant plusieurs configurations possibles pour le microrésonateur de la figure 7,
- les figures 11A et 11B sont des vues en coupe d'un microrésonateur selon une deuxième variante et ne faisant pas partie de l'invention,
- les figures 12A et 12B sont des vues respectivement en coupe et de dessus d'un microrésonateur selon la deuxième variante et ne faisant pas partie de l'invention,
- la figure 13 est une vue correspondant à la figure 12A du microrésonateur en cours d'utilisation,
- la figure 14 est une vue de dessus d'encore un autre microrésonateur selon la deuxième variante et ne faisant pas partie de réalisation,
- les figures 15A et 15B sont des vues respectivement en coupe et de dessus d'un microrésonateur selon une troisième variante et ne faisant pas partie de l'invention,
- les figures 16A à 16H sont des vues en coupe illustrant un procédé de réalisation d'un microrésonateur selon la première variante de l'invention.

### Description détaillée de modes de réalisation de l'invention

La description qui va suivre va porter sur trois variantes de réalisation.

Selon la première variante, la modification des conditions limites du résonateur provient d'une contrainte mécanique exercée sur la poutre formant résonateur. La contrainte mécanique peut résulter d'une force électrostatique provoquant une flexion de la poutre, avec ou sans modification de l'encastrement. La contrainte mécanique peut aussi résulter d'un effet de type bilame thermique provoquant une compression pure (dans le cas d'un double bilame) ou un effet cumulé de moment fléchissant et de compression (cas d'un bilame simple). La contrainte mécanique peut encore résulte, conformément à l'invention, d'une contrainte piézoélectrique amenée par l'excitation du résonateur lui-même (déformation du résonateur suivant sa longueur ou suivant son épaisseur par exemple).

Selon la deuxième variante, la modification des conditions aux limites du résonateur provient de l'application d'une charge variable sur le résonateur. La charge variable peut provenir du collage localisé d'une poutre supplémentaire ou poutre de charge sur le résonateur par le biais de forces électrostatiques.

Selon la troisième variante, la modification des conditions aux limites du résonateur provient d'une modification de sa température. La température du résonateur peut être modifiée et contrôlée par le biais d'une résistance chauffante placée sur la poutre formant résonateur.

Comme pour tout résonateur mécanique, cette variation de conditions limites (contraintes, charge, température) s'exprime par une variation de la fréquence de résonance du système (modification des conditions limites).

La possibilité de contrôler la fréquence de résonance des oscillateurs permet d'une part de relâcher le contrôle sur l'épaisseur de la couche de matériau piézoélectrique et, d'autre part, de contrôler de manière dynamique la résonance de chacun des oscillateurs pour réaliser un filtre accordable.

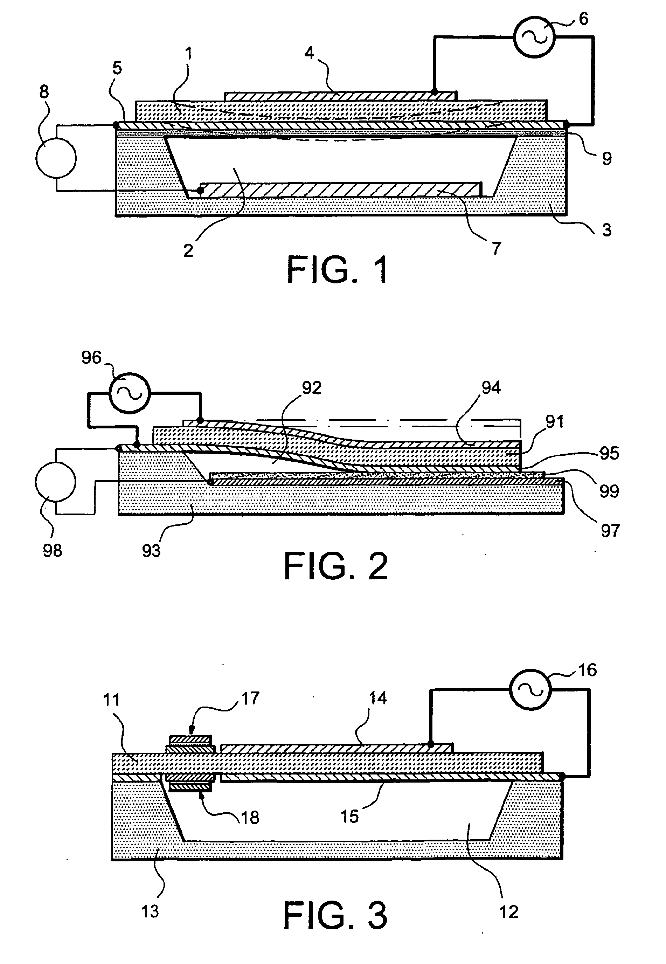

La figure 1 est une vue en coupe d'un microrésonateur selon la première variante et ne faisant pas partie de l'invention, dans le cas où la contrainte exercée sur la poutre provient d'une force électrostatique.

Une couche en matériau piézoélectrique 1 est suspendue au-dessus d'une cavité 2 réalisée dans un support 3. Elle est du type poutre encastrée à ses deux extrémités. La cavité 2 peut avoir entre quelques dixièmes et quelques dizaines de µm de profondeur, par exemple de 1 à 2 µm de profondeur. La poutre en matériau piézoélectrique 1 est prise en sandwich entre un premier jeu d'électrodes: une électrode supérieure 4 et une électrode inférieure 5. Ce premier jeu d'électrodes est destiné à soumettre la poutre à un ou des modes de résonance. Pour cela, les électrodes 4 et 5 sont reliées à un générateur de tension alternative 6 à la fréquence de résonance du mode choisi.

Un second jeu d'électrodes permet l'application d'une force électrostatique à la poutre. Ce second jeu d'électrodes peut être constitué par une électrode 7 disposée au fond de la cavité 2 et par l'électrode inférieure 5 disposée en vis-à-vis de l'électrode 7. Une tension de polarisation fournie par un générateur de courant continu 8 est appliquée entre les électrodes 5 et 7 pour induire une flexion de la poutre. Cette flexion génère une contrainte sur le résonateur, ce qui se traduit par une modification de sa fréquence de résonance. La contrainte étant fonction de la tension de polarisation, la fréquence de résonance est également liée à la tension de polarisation.

Pour des raisons de réalisation technologique, une couche 9 formant poutre support peut être intercalée entre le support 3 et le résonateur. La couche 9 peut être en nitrure ou en oxyde de silicium.

La déformation de la poutre 1 sous l'effet d'une force électrostatique a été représentée en traits interrompus.

La figure 2 est une vue en coupe d'un autre microrésonateur selon la première variante et ne faisant pas partie de l'invention, toujours dans le cas où la contrainte exercée sur la poutre provient d'une force électrostatique. A la différence de la poutre de la figure 1, la poutre formant résonateur est une poutre en porte à faux.

Une poutre en matériau piézoélectrique 91 est suspendue en porte à faux au-dessus d'une cavité ou évidement 92 d'un support 93. La poutre 91 est prise en sandwich entre une électrode supérieure 94 et une électrode inférieure 95 destinées à soumettre la poutre à un ou des modes de résonance. Pour cela, les électrodes 94 et 95 sont reliées à un générateur de tension alternative 96 à la fréquence de résonance du mode choisi.

Une électrode 97 est disposée au fond de la cavité 92 et est recouverte d'une couche de matériau diélectrique 99. Une tension de polarisation fournie par un générateur de tension continue 98 est appliquée entre les électrodes 95 et 97 pour induire une flexion de la poutre.

Sur la figure 2, la poutre 91 est représentée en traits interrompus en l'absence de tension de polarisation et en traits pleins pour une tension de polarisation appliquée. La couche de matériau diélectrique 99, continue ou discontinue (par exemple sous forme de petits plots diélectriques), évite tout court-circuit entre les électrodes 95 et 97. En fonction de la tension de polarisation appliquée, la poutre 91 est plus ou moins attirée vers le fond de la cavité 92.

La figure 3 est une vue en coupe d'un autre microrésonateur selon la première variante et ne faisant pas partie de l'invention, dans le cas où la contrainte exercée sur la poutre provient d'un effet bilame thermique.

Comme pour la figure 1, une poutre en matériau piézoélectrique 11 est suspendue au-dessus d'une cavité 12 réalisée dans un support 13. La cavité 12 peut avoir entre quelques dixièmes et quelques dizaines de µm de profondeur, par exemple de 1 à 2 µm de profondeur. La poutre en matériau piézoélectrique 11 est prise en sandwich entre une électrode supérieure 14 et une électrode inférieure 15 destinées à soumettre la poutre 11 à un ou des modes de résonance. Pour cela, les électrodes 14 et 15 sont reliées à un générateur de tension alternative 16 à la fréquence de résonance du mode choisi.

Un bilame thermique peut être disposé sur une ou plusieurs parties de la poutre, sur ou sous la poutre. Dans le cas représenté à la figure 3, la poutre supporte deux bilames thermiques 17 et 18 disposés en vis-à-vis sur chaque face de la poutre en matériau piézoélectrique 11. Chaque bilame 17 ou 18 est composé d'une couche à fort coefficient de dilatation thermique (en général une couche métallique) disposée sur la poutre en matériau piézoélectrique, qui est à faible coefficient de dilatation thermique, et d'un élément chauffant constitué d'une résistance électrique. L'élément chauffant peut faire partie de la couche à fort coefficient de dilatation thermique ou être une couche rapportée, isolée de la couche à fort coefficient de dilatation thermique par une couche mince diélectrique.

En faisant passer un courant dans la résistance électrique d'un élément chauffant, la température du bilame (constitué par la couche à fort coefficient de dilatation thermique et la poutre) augmente. Sous effet de cette élévation de température, la dilatation différentielle des deux matériaux du bilame génère une force de compression et un moment fléchissant sur la poutre. Si la poutre supporte deux bilames disposés comme sur la figure 2, la poutre n'est soumise qu'à une force de compression.

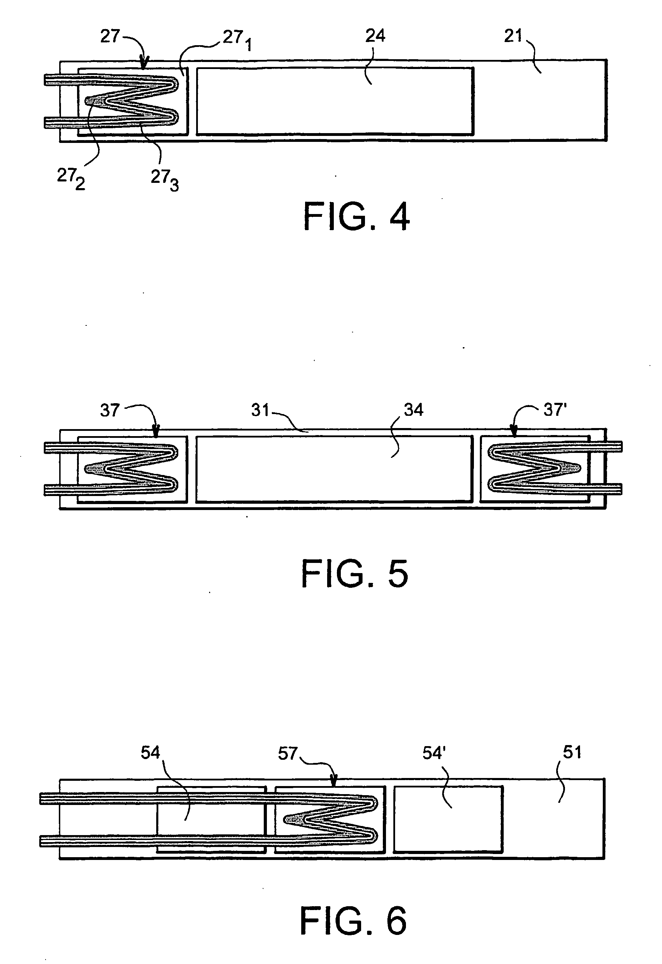

Les figures 4 à 6 sont des vues de dessus illustrant plusieurs dispositions possibles pour les bilames.

La figure 4 montre une couche de matériau piézoélectrique 21 formant poutre et supportant une électrode supérieure 24 destinée à l'application d'une tension alternative à la poutre. Le bilame 27, présent sur une extrémité de la face supérieure de la poutre, comprend en superposition une couche métallique 27₁ déposée sur la poutre, une couche d'isolant électrique 27₂ et une résistance électrique 27₃.

La figure 5 montre une couche de matériau piézoélectrique 31 formant poutre et supportant une électrode supérieure 34 d'excitation du résonateur. La poutre supporte, à chacune de ses extrémités et sur sa face supérieure, un bilame 37, 37' du type décrit à la figure 4.

La figure 6 montre une couche de matériau piézoélectrique 51 formant poutre et supportant une électrode supérieure en deux parties 54 et 54' formant l'électrode supérieure d'excitation du résonateur. La partie centrale de la poutre est occupée par un bilame 57 du type décrit à la figure 4.

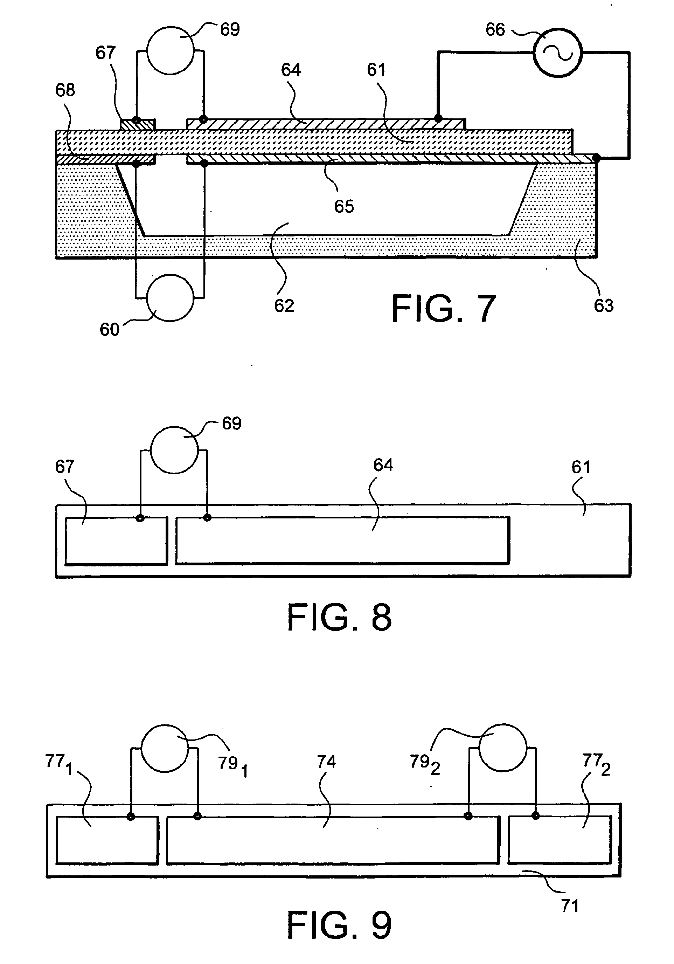

La figure 7 est une vue en coupe d'un microrésonateur selon la première variante et conformément à l'invention, dans le cas où la contrainte exercée sur la poutre provient d'une déformation du résonateur par effet piézoélectrique.

Comme pour les figures 1 et 3, une poutre en matériau piézoélectrique 61 est suspendue au-dessus d'une cavité 62 réalisée dans un support 63. La cavité 62 peut avoir entre quelques dixièmes et quelques dizaines de µm de profondeur, par exemple de 1 à 2 µm de profondeur. La poutre en matériau piézoélectrique 61 est prise en sandwich entre une électrode supérieure 64 et une électrode inférieure 65 destinées à l'excitation de la poutre. Pour cela, les électrodes 64 et 65 sont reliées à un générateur de tension alternative 66 à la fréquence de résonance du mode choisi.

Sur une ou plusieurs parties de la poutre, sur la face supérieure et/ou sur la face inférieure, des électrodes supplémentaires sont disposées pour générer un champ électrique continu dans la poutre en matériau piézoélectrique 61. L'arrangement de ces électrodes dépend de l'orientation du cristal piézoélectrique et de la direction de déformation désirée. Dans le cas de la figure 7, une électrode supplémentaire 67 est disposée sur la face supérieure de la poutre et une électrode supplémentaire 68 est disposée sur la face inférieure de la poutre. Les électrodes 64 et 67 sont reliées à un premier générateur de tension continue 69. Les électrodes 65 et 68 sont reliées à un deuxième générateur de tension continue 60. Les déformations locales générées par les tensions continues appliquées aux électrodes 64 et 67 d'une part et 65 et 68 d'autre part, ont pour effet de faire varier la fréquence de résonance du résonateur.

Les figures 8 à 10 sont des vues de dessus illustrant plusieurs dispositions possibles pour les électrodes supplémentaires.

La figure 8 reproduit le cas de la face supérieure de la poutre en matériau piézoélectrique 61 où l'électrode 64 d'excitation du résonateur et l'électrode supplémentaire 67 sont reliées au générateur de tension continue 69 (voir la figure 7). Le champ électrique induit par la tension continue entre les électrodes 64 et 67 est à l'origine de la contrainte mécanique.

La figure 9 représente une variante pour laquelle la poutre en matériau piézoélectrique 71 supporte, sur sa face supérieure, une électrode 74 d'excitation du résonateur et deux électrodes supplémentaires 77₁ et 77₂ situées de chaque côté de l'électrode d'excitation 74. Les électrodes 74 et 77₁ sont reliées à un premier générateur de tension continue 79₁ pour induire un champ électrique entre ces électrodes. Les électrodes 74 et 77₂ sont reliées à un deuxième générateur de tension continue 79₂ pour induire un champ électrique entre ces électrodes. Les champs électriques induits par ces tensions continues sont à l'origine de contraintes mécaniques dans la poutre en matériau piézoélectrique 71.

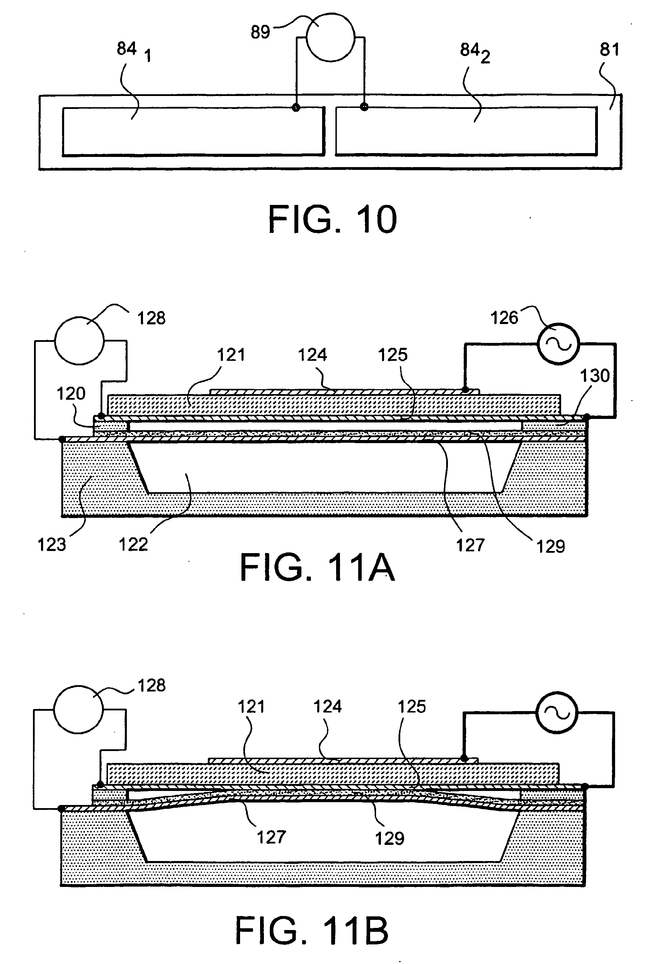

La figure 10 représente une variante pour laquelle la poutre en matériau piézoélectrique 81 supporte, sur sa face supérieure, une électrode d'excitation du résonateur en deux parties 84₁ et 84₂. Chaque partie 84₁ et 84₂ est reliée à un générateur de tension continue 89 qui induit un champ électrique dans l'intervalle séparant les parties 84₁ et 84₂.

Les figures 11A et 11B sont des vues en coupe d'un microrésonateur selon la deuxième variante et ne faisant pas partie de l'invention. Selon cette variante, une charge variable est appliquée au résonateur.

Une poutre en matériau piézoélectrique 121 est suspendue au-dessus d'une cavité 122 réalisée dans un support 123. La cavité 122 peut avoir 1 ou 2 µm de profondeur. La poutre en matériau piézoélectrique 121 est prise en sandwich entre une électrode supérieure 124 et une électrode inférieure 125 destinées à l'excitation de la poutre. Pour cela, les électrodes 124 et 125 sont reliées à un générateur de tension alternative 126 à la fréquence de résonance du mode choisi.

L'ensemble constitué par la poutre 121 et les électrodes 124 et 125 est solidaire du support 123 par l'intermédiaire des éléments 127, 129, 120 et 130. L'élément 127 est une électrode solidaire du support 123 et surplombant la cavité 122. Elle est recouverte d'une couche de matériau diélectrique 129. Les éléments 120 et 130 sont des espaceurs maintenant, en l'absence d'une tension continue appliquée entre les électrodes 125 et 127 par le générateur de tension 128, un écartement entre l'ensemble des éléments 125-121-124 et l'ensemble des éléments 127-129 qui constitue une poutre de charge. C'est ce que montre la figure 11A.

La figure 11B représente le cas où une tension de polarisation est fournie par le générateur de tension 128 entre les électrodes 125 et 127 pour coller une partie de la poutre de charge sur l'ensemble des éléments 125-121-124. La surface de collage est plus ou moins importante en fonction de la tension de polarisation. La surface de collage permet de faire varier la charge appliquée sur le résonateur et donc la fréquence de résonance du résonateur.

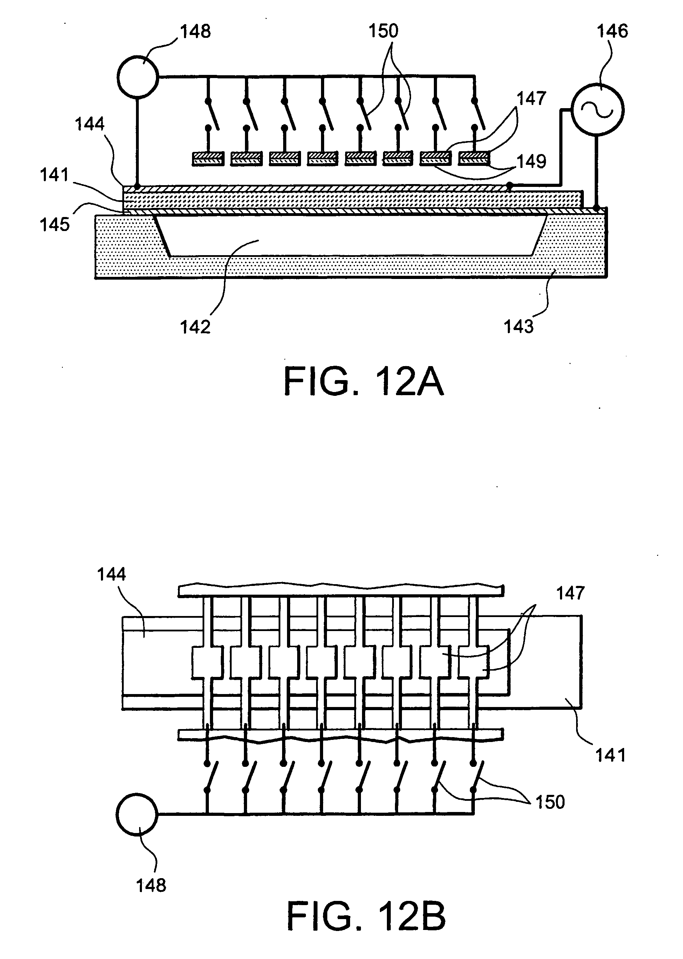

Les figures 12A et 12B sont des vues respectivement en coupe et de dessus d'un autre microrésonateur selon la deuxième variante et ne faisant pas partie de l'invention.

Une poutre en matériau piézoélectrique 141 est suspendue au-dessus d'une cavité 142 réalisée dans un support 143. La cavité 142 peut avoir 1 ou 2µm de profondeur. La poutre en matériau piézoélectrique 141 est prise en sandwich entre une électrode supérieure 144 et une électrode inférieure 145 destinées à l'excitation de la poutre. Pour cela, les électrodes 144 et 145 sont reliées à un générateur de tension alternative 146 à la fréquence de résonance du mode choisi.

Contrairement au microrésonateur représenté aux figures 11A et 11B qui ne comprend qu'une seule poutre de charge, le microrésonateur représenté aux figures 12A et 12B comprend plusieurs poutres de charge. Ces poutres de charge 149 sont placées au-dessus ou au-dessous de la poutre 141. Elles sont actionnées par des électrodes 147. Dans le cas représenté ici, les poutres de charge sont des couches diélectriques supportées par le support 143, continues ou discontinues, disposées au-dessus de la poutre 141. Les électrodes d'actionnement 147 sont des couches métalliques déposées sur les poutres de charge 149. Un générateur de tension continue 148 est connecté entre l'électrode supérieure 144 et, par l'intermédiaire de commutateurs 150, les électrodes d'actionnement 147.

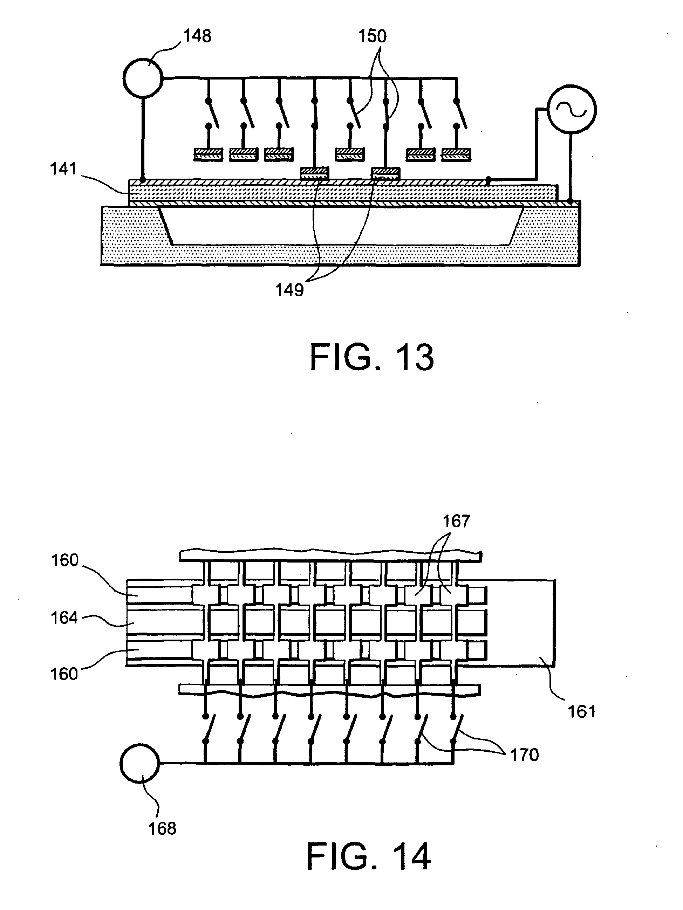

La figure 12A montre le microrésonateur en absence de contrainte mécanique appliquée à la poutre 141. La variation de la fréquence de résonance se fait de manière discrète, par paliers, au fur et à mesure du collage de chacune des poutres de charge sur la porte 141. Ainsi, la figure 13 montre le cas où deux poutres de charge 149 sont appliquées sur la poutre 141 suite à la fermeture de leur commutateur correspondant 150.

Dans le cas ci-dessus, la contre-électrode utilisée pour défléchir les poutres de charge est l'électrode supérieure de la poutre en matériau piézoélectrique. Il est cependant possible d'utiliser une contre-électrode distincte de cette électrode supérieure. C'est ce que montre la figure 14 qui est une vue de dessus d'encore un autre microrésonateur selon la deuxième variante de réalisation.

La figure 14 montre une poutre en matériau piézoélectrique 161 supportant, selon son axe longitudinal, une électrode supérieure d'excitation 164. La poutre 161 supporte également une contre-électrode 160 formée de deux bandes conductrices situées de part et d'autre de l'électrode d'excitation 164. Les poutres de charge sont comme précédemment disposées au-dessus de la poutre 161 et transversalement par rapport à la poutre 161. Elles sont recouvertes d'électrodes d'actionnement 167 possédant des parties élargies en regard des bandes conductrices de la contre-électrode 160. Un générateur de tension continue 168 est connecté entre la contre-électrode 160 et, par l'intermédiaire de commutateurs 170, les électrodes d'actionnement 167.

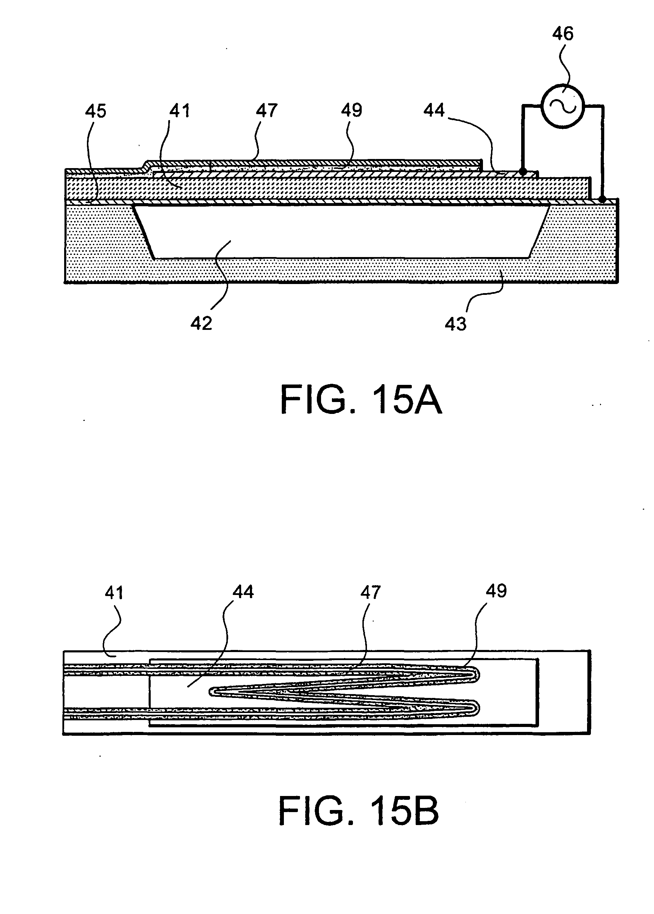

Les figures 15A et 15B sont des vues respectivement en coupe et de dessus illustrant un microrésonateur selon la troisième variante et ne faisant pas partie de l'invention. Selon cette variante, la température du résonateur est modifiée.

Une poutre en matériau piézoélectrique 41 est suspendue au-dessus d'une cavité 42 réalisée dans un support 43. La cavité 42 peut avoir 1 ou 2 µm de profondeur. La poutre en matériau piézoélectrique 41 est prise en sandwich entre une électrode supérieure 44 et une électrode inférieure 45 destinées à l'excitation de la poutre. Pour cela, les électrodes 44 et 45 sont reliées à un générateur de tension alternative 46 à la fréquence de résonance du mode choisi.

L'électrode d'excitation 44 supporte successivement une couche de matériau diélectrique 49 servant d'isolant électrique et une résistance chauffante 47 filiforme. L'élévation de température induit par le passage d'un courant électrique dans la résistance 47 modifie les caractéristiques du résonateur, ce qui se traduit par une variation de la fréquence de résonance.

Dans les différentes variantes du microrésonateur représentées ci-dessus, la poutre est écartée du support par la présence d'une cavité. Une autre façon de faire serait de graver entièrement la face arrière du support pour libérer la poutre.

La couche 9 formant poutre support visible sur la figure 1 peut également être présente dans les autres variantes de microrésonateurs.

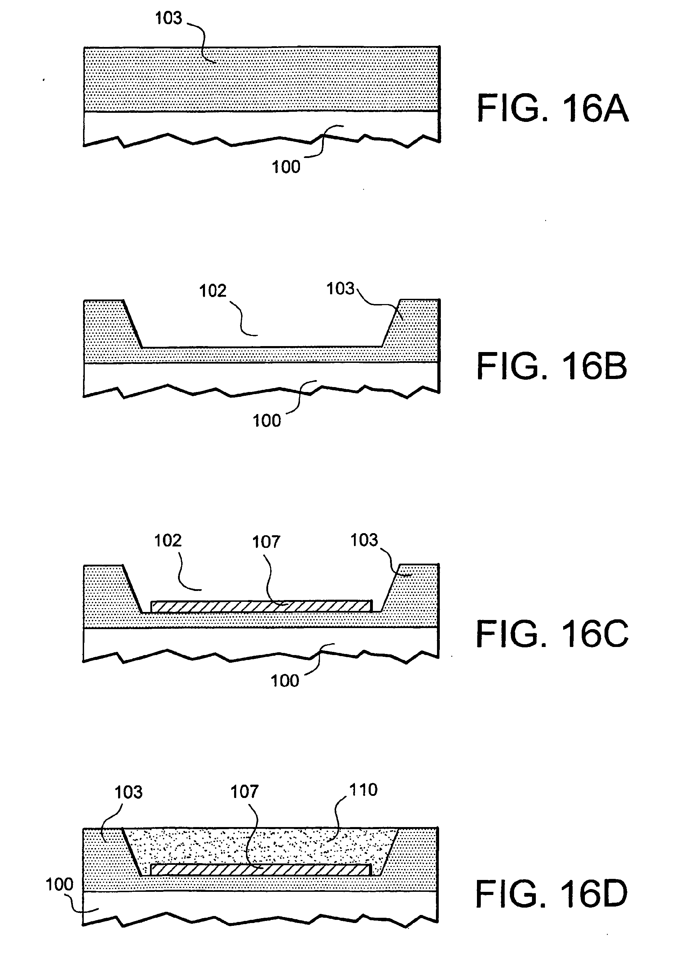

La réalisation d'un microrésonateur selon l'invention va maintenant être présentée. Cette réalisation est illustrée par les figures 16A à 16H.

La figure 16A montre un support constitué par un substrat de silicium 100 sur une face duquel a été déposée une couche 103 d'oxyde de silicium de 2 µm d'épaisseur.

Dans la couche 103 d'oxyde de silicium, une cavité 102 de 1,5 µm de profondeur est réalisée. C'est ce que montre la figure 16B.

Un dépôt métallique de 0,8 µm d'épaisseur est effectué au fond de la cavité 102 pour fournir l'électrode 107 destinée à déformer et contraindre le résonateur. C'est ce que montre la figure 16C.

Ensuite, une couche sacrificielle 110 est déposée dans la partie restante de la cavité pour la combler et atteindre le niveau supérieur de la couche 103. C'est ce que montre la figure 16D.

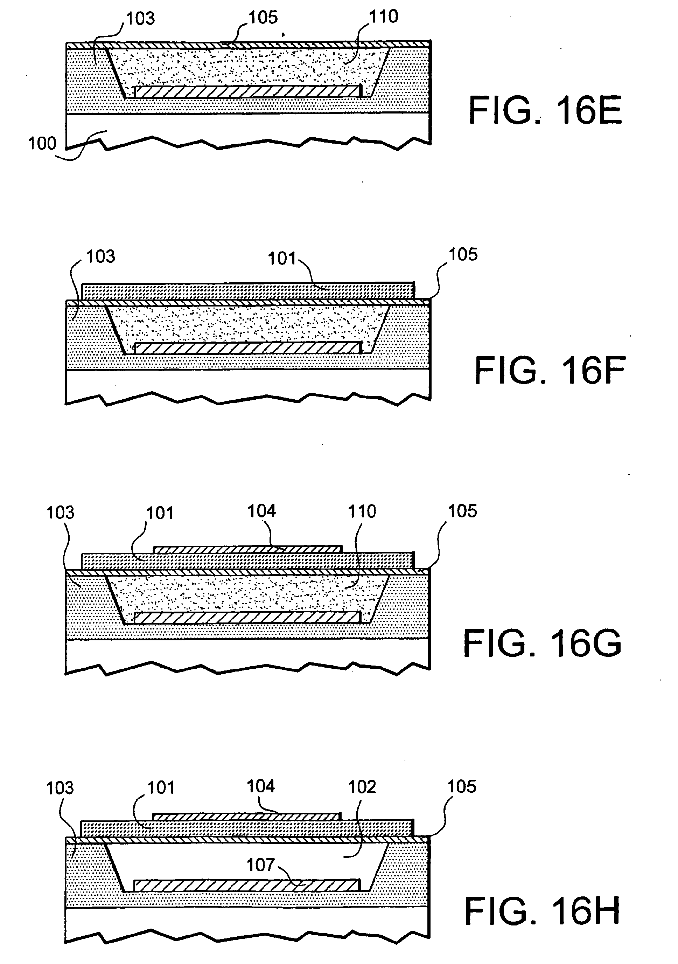

Un dépôt métallique de 0,2 µm d'épaisseur est réalisé afin d'obtenir l'électrode inférieure 105 d'excitation du résonateur. C'est ce que montre la figure 16E.

Sur l'électrode inférieure 105, on dépose alors la poutre en matériau piézoélectrique 101 du résonateur. C'est ce que montre la figure 16F.

Ensuite un dépôt métallique de 0,2 µm d'épaisseur est effectué sur la poutre en matériau piézoélectrique 101 pour obtenir l'électrode supérieure 104 d'excitation du résonateur. C'est ce que montre la figure 16G.

Enfin, on procède au retrait de la couche sacrificielle 110 pour libérer le résonateur et obtenir la structure représentée à la figure 16H.

La présente invention permet donc de réaliser des résonateurs et filtres RF intégrés et accordables par un procédé de réalisation compatible avec la fabrication de circuits intégrés. Elle permet la réalisation de filtres plus "robustes" puisque l'ajustage des fréquences de résonance de chaque oscillateur peut se faire après la fabrication, par contrôle de la contrainte mécanique et non plus uniquement par un contrôle très précis de l'épaisseur de la poutre en matériau piézoélectrique. Elle rend possible la réalisation d'un filtre accordable.

## Revendications

1. Microrésonateur à ondes acoustiques de volume suspendu, comprenant une poutre en matériau piézoélectrique (1, 11, 61, 91, 101, 121) solidaire d'un support (3,13, 63, 93, 103, 123) et d'épaisseur prévue pour fonctionner à une fréquence de résonance donnée, la poutre étant prise en sandwich selon son épaisseur entre des électrodes d'excitation (4, 5 ; 14, 15 ; 64, 65 ; 94, 95 ; 104, 105 ; 124, 125), le microrésonateur comprenant en outre des moyens piézoélectriques permettant de modifier ladite fréquence de résonance, **caractérisé en ce que** les moyens piézoélectriques comprennent, sur au moins l'une des faces de la poutre, des électrodes (64, 67, 65, 68), dont au moins une est une électrode supplémentaire différente des électrodes d'excitation, permettant l'application d'un champ électrique à la poutre, d'où il résulte une contrainte de compression/dilatation ou de cisaillement dans le plan de la poutre.

2. Microrésonateur selon la revendication 1, **caractérisé en ce que** l'une des électrodes des moyens piézoélectriques est une électrode d'excitation.

3. Microrésonateur selon l'une des revendications précédentes, **caractérisé en ce que** la poutre en matériau piézoélectrique munie de ses électrodes d'excitation est solidaire du support par l'intermédiaire d'une couche en matériau diélectrique.

## Claims

1. Suspended film bulk acoustic micro-resonator, comprising a beam made of a piezoelectric material (1, 11, 61, 91, 101, 121) fixed to a support (3, 13, 63, 93, 103, 123) and with a thickness selected to operate at a given resonant frequency, the beam being sandwiched in the direction of its thickness between excitation electrodes (4, 5; 14, 15; 64, 65; 94, 95; 104, 105; 124, 125), the micro-resonator further comprising piezoelectric means of modifying said resonant frequency,
**characterised in that** the piezoelectric means include electrodes (64, 67, 65, 68) on at least one face of the beam, wherein at least one is a supplementary electrode different from the excitation electrodes, for applying an electric field to the beam, which results in a compression / expansion stress or a shear stress in the plane of the beam.

2. Micro-resonator according to claim 1, **characterised in that** one of the electrodes of the piezoelectric means is an excitation electrode.

3. Micro-resonator according to any one of the above claims, **characterised in that** the beam made of a piezoelectric material provided with its excitation electrodes is fixed to the support through a layer of a dielectric material.

## Patentansprüche

1. Aufgehängter Volumenschallwellen-Mikroresonator, umfassend einen Träger aus piezoelektrischem Material (1, 11, 61, 91, 101, 121), der mit einem Substrat (3, 13, 63, 93, 103, 123) verbunden ist und eine Dicke aufweist, die derart vorgesehen ist, dass er bei einer vorgegebenen Resonanzfrequenz funktioniert, wobei der Träger in der Dickenrichtung sandwichförmig zwischen Anregungselektroden (4, 5; 14, 15; 64, 65; 94, 95; 104, 105; 124, 125) gegriffen ist, wobei der Mikroresonator ferner piezoelektrische Mittel umfasst, die eine Modifizierung der Resonanzfrequenz erlauben, **dadurch gekennzeichnet, dass** die piezoelektrischen Mittel an wenigstens einer Seite des Trägers Elektroden (64, 67, 65, 68) umfassen, von denen wenigstens eine eine von den Anregungselektroden verschiedene zusätzliche Elektrode ist, die das Anlegen eines elektrischen Felds an den Träger erlaubt, woraus eine Beschränkung der Kompression/Dilatation oder der Scherung in der Ebene des Trägers resultiert.

2. Mikroresonator nach Anspruch 1, **dadurch gekennzeichnet, dass** eine der Elektroden der piezoelektrischen Mittel eine Anregungselektrode ist.

3. Mikroresonator nach einem der vorhergehenden Ansprüche, **dadurch gekennzeichnet, dass** der Träger aus piezoelektrischem Material, der mit seinen Anregungselektroden ausgestattet ist, mittels einer Schicht aus dielektrischem Material mit dem Substrat verbunden ist.
